# EUROPEAN PATENT APPLICATION

(11) **EP 0 627 506 A1**
(43) Date of publication of application: **07.12.1994**
(21) Application number: 94303984.2
(22) Date of filing: 03.06.1994
(51) Int. Cl.: C30B 33/00, C30B 29/48

(54) **CdTe crystal for use in radiation detector and method of manufacturing such CdTe crystal**

(30) Priority: 04.06.1993 JP 134657/93
(71) Applicant: JAPAN ENERGY CORPORATION, Minato-ku, Tokyo (JP)
(72) Inventor: Ohno, Ryoichi, c/o Japan Energy Corporation, Toda-shi, Saitama-ken (JP); Iwase, Yoshimichi, c/o Japan Energy Corporation, Toda-shi, Saitama-ken (JP)
(74) Representative: Perry, Robert Edward

(57) **Abstract**

A cadmium telluride crystal ingot with a small amount of chlorine added or a wafer cut out of such a cadmium telluride crystal ingot is heat-treated at a temperature ranging from 250°C to 450°C for at least 20 hours. The cadmium telluride crystal thus heat-treated has a value µτ of at least 2.0 x 10⁻³cm²/V, which is the product of the carrier mobility µ and the carrier life τ. A radiation detector made of the cadmium telluride crystal has a stable output signal for a long period of time after an X ray starts being applied thereto.

## Description

### BACKGROUND OF THE INVENTION

### Field of the Invention:

The present invention relates to a chlorine-doped CdTe crystal for use in a radiation detector, and a method of manufacturing such a chlorine-doped CdTe crystal.

### Description of Related Art:

Cadmium telluride (CdTe) is a semiconductor having a higher radiation absorption coefficient and a larger energy gap at normal temperature than silicon (Si) and germanium (Ge). Therefore, radiation detectors made of CdTe have better characteristics than those made of Si and Ge.

It has been customary for CdTe radiation detectors to have a general structure in which two electrodes are attached to two respective confronting surfaces of a crystal for applying a bias voltage therebetween. The CdTe radiation detectors of such a structure detect a current which is produced when positive and negative carriers (hole-electron pairs) generated when the CdTe crystal is exposed to a radiation are attracted to the electrodes.

It is important that CdTe crystals for use in radiation detectors have a high electric resistance so that no current flows when they are not exposed to any radiation, and that positive and negative carriers generated by exposure to a radiation have a long life in order to increase the radiation-to-current conversion factor.

Heretofore, it has been known that high-resistance CdTe crystals which meet the above requirements can be produced by doping CdTe crystals with chlorine. For increasing the carrier life, it is necessary to reduce the amount of chlorine to be doped. Japanese laid-open patent publications Nos. 4-97990, 4-97991, and 4-97992, for example, disclose proposals for reducing the amount of chlorine to be doped. According to the disclosed processes, a chlorine-doped CdTe crystal is heat-treated at a temperature in the range of from 350 to 450°C after the crystal has been formed, or annealed in a temperature range up to 450°C or lower, for thereby producing a device of high energy resolution which is made of a crystal having a low chlorine content.

Japanese laid-open patent publication No. 3-349400 reveals a process of producing a device of high energy resolution by heat-treating a chlorine-doped CdTe crystal ingot, which has been grown by THM (traveling heater method), in a temperature range from 500 to 900°C, and then heat-treating the chlorine-doped CdTe crystal ingot at a temperature of 450°C or lower.

However, it has been found that when a radiation detector made of a chlorine-doped CdTe crystal heat-treated according to the conventional process is in continuous operation under a high radiation dose of at least 100 kcps, the output signal of the radiation detector, i.e., the radiation detection capability thereof, drops in a short period of time.

### SUMMARY OF THE INVENTION

It is therefore an object of the present invention to provide a chlorine-doped CdTe crystal which allows a radiation detector made of such a chlorine-doped CdTe crystal to sustain its output signal level during continuous operation under a high radiation dose, and a method of manufacturing such a chlorine-doped CdTe crystal.

According to the present invention, there is provided a cadmium telluride crystal for use in a radiation detector wherein the product µτ of the carrier mobility µ and the carrier life τ has a value of at least 2.0 × 10⁻³cm²/V.

According to the present invention, there is also provided a radiation detector made of a cadmium telluride crystal wherein the product µτ of the carrier mobility µ and the carrier life τ has a value of at least 2.0 × 10⁻³cm²/V.

According to the present invention, there is further provided a method of manufacturing a cadmium telluride crystal for use in a radiation detector, comprising the step of heat-treating a cadmium telluride crystal ingot with a small amount of chlorine added or a wafer cut out of such a cadmium telluride crystal ingot at a temperature ranging from 250°C to 450°C for at least 20 hours.

According to the present invention, there is also provided a method of manufacturing a cadmium telluride crystal, comprising the steps of producing a wafer of chlorine-doped cadmium telluride crystal, and heat-treating the wafer at a temperature ranging from 250°C to 450°C for at least 20 hours.

According to the present invention, there is also provided a method of manufacturing a radiation detector, comprising the steps of producing a wafer of chlorine-doped cadmium telluride crystal, heat-treating the wafer at a temperature ranging from 250°C to 450°C for at least 20 hours, and cutting a portion out of the wafer as a radiation detector.

The above and other objects, features, and advantages of the present invention will become apparent from the following description when taken in conjunction with the accompanying drawings illustrates preferred embodiments of the present invention by way of example.

### BRIEF DESCRIPTION OF THE DRAWINGS

FIG. 1 is a timing chart showing a heating pattern for heat-treating wafer segments; and
FIG. 2 is a view showing different regions of the wafer segments heat-treated at 380°C according to the heating pattern shown in FIG. 1 for various periods of time.

### DETAILED DESCRIPTION OF THE PREFERRED EMBODIMENTS

The inventors conducted an experiment in order to produce a CdTe crystal suitable for use in a radiation detector whose output signal level will not drop even under a high radiation dose.

In the experiment, a CdTe crystal ingot with 2 weight ppm of chlorine added was grown by THM, and two wafer segments each 2.5 mm thick were cut out of the CdTe crystal ingot. The wafer segments were heat-treated according to the process disclosed in Japanese laid-open patent publication No. 4-97990. Specifically, one of the wafer segments was heat-treated at 380°C for 15 hours in an inert gas atmosphere and the other wafer segment was heat-treated at the same temperature for 24 hours in the same inert gas atmosphere. After both surfaces of each of the wafer segments were ground and etched, an indium electrode layer and a platinum electrode layer were deposited on the respective surfaces of each of the wafer segments. Radiation detectors each having vertical and horizontal dimensions of 2 mm and a thickness of 2 mm were cut out of each of the wafer segments.

Then, while a voltage of 500 V was being applied between the electrodes of each of the radiation detectors, an X ray of 10⁻² roentgen/sec. was applied to the radiation detectors, and the output signals from the radiation detectors were measured for any change. As a result, it was found that the radiation detector made of the crystal heat-treated for the longer period of time produced a more stable output signal for a long time after the start of the application of the X ray.

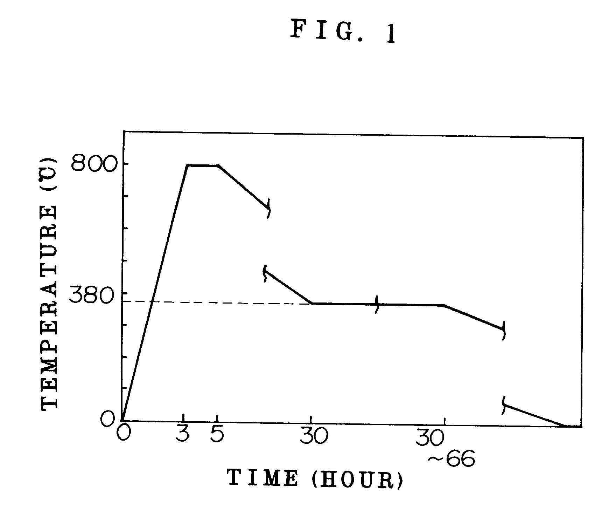

In order to obtain a qualitative evaluation of the relationship between the heat-treatment time and the output signal stability, a CdTe crystal ingot with 2 weight ppm of chlorine added was grown by THM, and four wafer segments were cut out of the CdTe crystal ingot. Each of the four wafer segments was heat-treated according to a heating pattern shown in FIG. 1 at 380°C for 0, 15, 24, and 36 hours, respectively.

Thereafter, both surfaces of each of the wafers were ground and etched, and then an indium electrode layer and a platinum electrode layer were deposited on the respective surfaces of each of the wafer segments. Current-mode radiation detectors each having vertical and horizontal dimensions of 2 mm and a thickness of 2 mm were then cut out of each of the wafer segments. An X-ray detection test was conducted on the radiation detectors thus produced.

About half of the radiation detectors produced from the wafer segment which was heat-treated for 24 hours exhibited output signal stability for 30 seconds or more after an X ray started being applied thereto, and all the radiation detectors produced from the wafer segment which was heat-treated for 36 hours exhibited output signal stability for 30 seconds or more after an X ray started being applied thereto. All the radiation detectors produced from the wafer segments which were heat-treated for 0 and 15 hours exhibited no output signal stability.

The above phenomenon is considered to arise out of the fact that if a radiation detector containing a location (defect) which stores a slight amount of electric charge operates under a high radiation dose, then the output signal level of the radiation detector drops sharply with time.

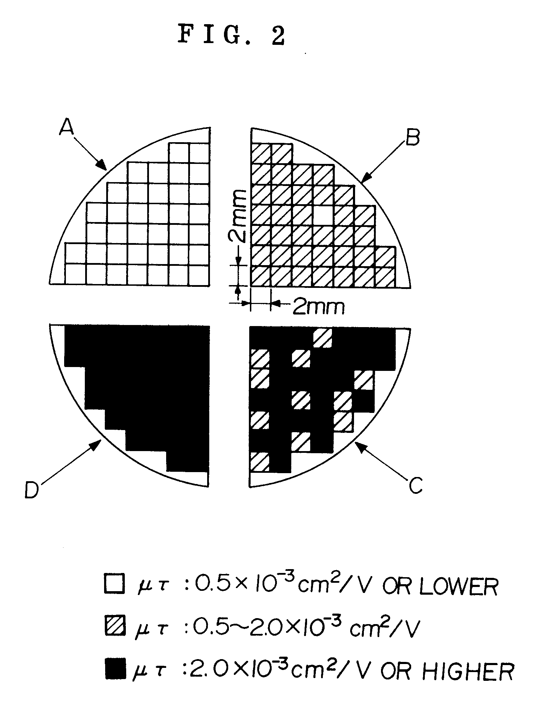

The above difference between the characteristics of the radiation detectors led the inventors to think that the output signal stability of a radiation detection during operation under a high radiation dose may be related to the product µτ of the carrier mobility µ and the carrier life τ in the wafer. The inventors measured the carrier mobility µ and the carrier life τ with respect to each of the wafer segments. The results of the measurement are shown in FIG. 2. In FIG. 2, regions indicated by o in the wafer segments had a µτ value of less than 0.5 × 10⁻³cm²/V, regions indicated by η in the wafer segments had a µτ value of 2.0 × 10⁻³cm²/V or higher and other regions in the wafer segments had a µτ value of 0.5 × 10⁻³cm²/V or higher and less than 2.0 × 10⁻³cm²/V.

In FIG. 2, the wafer segment indicated at A was heat-treated for 0 hour, and the wafer segments indicated at B, C, D were heat-treated for 15, 24, and 36 hours, respectively.

It can be seen from FIG. 2 that no regions of the wafer segments A, B heat-treated for 0 and 15 hours had a µτ value of 2.0 × 10⁻³cm²/V or higher, and about half of the regions of the wafer segment C heat-treated for 24 hours and all the regions of the wafer segment C heat-treated for 36 hours had a µτ value of 2.0 × 10⁻³cm²/V or higher. This result agrees with the above result of the X ray measurement for output signal stability. Based on the above analysis, the inventors have formed the conclusion that the output signal stability is greatly related to the µτ value.

The µτ values of the regions which were of 2.0 × 10⁻³cm²/V or higher were in the range of from 2.0 × 10⁻³cm²/V to 2.5 × 10⁻³cm²/V.

A study of FIG. 2 clearly indicates that the µτ value increases as the heat treatment time increases. When heat-treated at 380°C for 20 hours or longer, there can be produced a wafer having a µτ value of 2.0 × 10⁻³cm²/V or higher.

The present invention is based on the above finding, and provides a CdTe crystal where the product µτ of the carrier mobility µ and the carrier life τ has a value of 2.0 × 10⁻³cm²/V or higher, for use in a radiation detector particularly suitable for the detection of a high radiation dose.

According to a further embodiment of the present invention, a CdTe crystal ingot with a small amount of chlorine added or a wafer cut out of such a CdTe crystal ingot is heat-treated at a temperature ranging from 250°C to 450°C for at least 20 hours to produce a CdTe crystal where the product µτ of the carrier mobility µ and the carrier life τ has a value of 2.0 × 10⁻³cm²/V or higher.

The amount of chlorine added to the CdTe crystal ingot ranges from 0.8 weight ppm to 5 weight ppm. If the amount of chlorine added were less than 0.8 weight ppm, then the resistivity of the CdTe crystal ingot would be too low. If the amount of chlorine added exceeded 5 weight ppm, the carrier life time would be too short.

If the CdTe crystal ingot or the wafer cut out of it were heat-treated at a temperature lower than 250°C, then no desired resistance would be achieved, and the µτ value would not become 2.0 × 10⁻³cm²/V or higher even when heat-treated for a long period of time. If the CdTe crystal ingot or the wafer cut out of it were heat-treated at a temperature beyond 450°C, then the resistivity would become too low to produce a crystal having a resistivity of 10⁸ Ω·cm or higher which is required by a radiation detector.

The CdTe crystal ingot or the wafer cut out of it is heat-treated for 20 hours or longer because of the experimental results which show the need for heat-treatment at 450°C for about 20 hours and heat-treatment at 350°C for about 35 hours in order to make uniform the µτ values at 2.0 × 10⁻³cm²/V or higher.

A radiation detector which is made of a CdTe crystal having a value µτ of 2.0 × 10⁻³cm²/V or higher can produce a stable output signal for a long period of time during operation under a high radiation dose.

### Inventive Example 1:

100 mm of a CdTe crystal ingot with 2 ppm weight of chlorine added was grown at 800°C by THM. The crystal ingot was then vacuum-sealed in a quartz ampul, heated up to 800°C and then cooled down to 350°C in 20 hours. Then, the temperature of the crystal ingot was maintained at 350°C for 35 hours, and then cooled down to room temperature in 30 hours.

A wafer 2.5 mm thick was cut out of the CdTe crystal ingot. The wafer was ground to a mirror finish and etched to a thickness of 2.0 mm. Then, an indium electrode layer and a platinum electrode layer were deposited on the respective surfaces of the wafer. The wafer was cut into radiation detectors each having vertical and horizontal dimensions of 2 mm and a thickness of 2 mm.

Then, while a voltage of 500 V was being applied between the electrodes of each of the radiation detectors, an X-ray of 10⁻² roentgen/sec. was applied to the radiation detectors, and the output currents from the radiation detectors were measured for any change from the start of the application of the X-ray. As a result, it was found that the output currents from all the radiation detectors varied within ± 2 % for 30 seconds after starting application of the X-ray thereto.

### Inventive Example 2:

A chlorine-doped CdTe crystal ingot was grown under the same conditions as those in Inventive Example 1, and a wafer 2.5 mm thick was cut out of a central region of the CdTe crystal ingot. The wafer was heated up and the temperature maintained at 800°C in an argon atmosphere for 10 hours, and then cooled down to room temperature in 20 hours. Then, the wafer was heated up and the temperature maintained at 300°C in an argon atmosphere for 30 hours, and then cooled down to room temperature in 10 hours.

An indium electrode layer and a platinum electrode layer were deposited on the respective surfaces of the wafer. The wafer was cut into radiation detectors each having vertical and horizontal dimensions of 2 mm and a thickness of 2 mm. The radiation detectors were then measured for output current changes after starting application of the X-ray. As a result, it was found that the output currents from all the radiation detectors varied within ± 2 % for 30 seconds after starting application of the X-ray thereto.

### Comparative Example:

A chlorine-doped CdTe crystal ingot was grown under the same conditions as those in Inventive Example 1. The chlorine-doped CdTe crystal ingot was then vacuum-sealed in a quartz ampul, heated up to 800°C and then cooled down to 350°C in 20 hours. Then, the crystal ingot was held at 350°C for 18 hours, and then cooled down to room temperature in 30 hours.

A wafer 2.5 mm thick was cut out of the CdTe crystal ingot. An indium electrode layer and a platinum electrode layer were deposited on the respective surfaces of the wafer. The wafer was cut into radiation detectors each having vertical and horizontal dimensions of 2 mm and a thickness of 2 mm. The radiation detectors were then measured for output signal changes after starting application of the X-ray. As a result, it was found that the output signals from all the radiation detectors dropped 20 % or more within 30 seconds after starting application of the X-ray thereto.

While a radiation detector has been fabricated from a CdTe crystal grown by THM in the above embodiments, the present invention is applicable to the fabrication of a radiation detector from a CdTe crystal grown by the Bridgman method or any of various other methods.

In each of the above Examples, the chlorine-doped CdTe crystal ingot grown by THM was heated up to 800°C, or a temperature ranging from 500 to 900°C, in order to reduce the effect of the heat history after the CdTe crystal was formed. However, such a heating process is not an indispensable requirement of the present invention, but is effective to reduce variations of electric characteristics due to the crystal position in the case where a CdTe crystal grown by THM is used.

Although certain preferred embodiments of the present invention have been shown and described in detail, it should be understood that various changes and modifications may be made therein without departing from the scope of the appended claims.

## Claims

1. A cadmium telluride crystal for use in a radiation detector wherein the product µτ of the carrier mobility µ and the carrier life τ of the crystal has a value of at least 2.0 × 10⁻³cm²/V.

2. A radiation detector made of a cadmium telluride crystal wherein the product µτ of the carrier mobility µ and the carrier life τ of the crystal has a value of at least 2.0 × 10⁻³cm²/V.

3. A method of manufacturing a cadmium telluride crystal for use in a radiation detector, comprising the step of:
heat-treating a cadmium telluride crystal ingot with a small amount of chlorine added or a wafer cut out of such a cadmium telluride crystal ingot at a temperature ranging from 250°C to 450°C for at least 20 hours.

4. A method of manufacturing a cadmium telluride crystal, comprising the steps of:
producing a wafer of chlorine-doped cadmium telluride crystal; and
heat-treating said wafer at a temperature ranging from 250°C to 450°C for at least 20 hours.

5. A method of manufacturing a radiation detector, comprising the steps of:
producing a wafer of chlorine-doped cadmium telluride crystal;
heat-treating said wafer at a temperature ranging from 250°C to 450°C for at least 20 hours; and
cutting a portion out of said heat treated wafer to produce the radiation detector.
